# DEMANDE DE BREVET EUROPEEN

(11) **EP 0 585 169 A1**
(43) Date de publication de la demande: **02.03.1994**
(21) Numéro de dépôt: 93402074.4
(22) Date de dépôt: 18.08.1993
(51) Int. Cl.: H04B 1/20, H03J 1/00

(54) **Procédé pour exploiter des signaux de télécommande, dispositif de télécommande, et unités fonctionnelles et installation s'y rapportant**

(30) Priorité: 26.08.1992 FR 9210289
(71) Demandeur: EURO CP s.a.r.l., F-94240 l'Hay les Roses (FR)
(72) Inventeur: Gilbert, Jérôme, F-92300 Levallois Perret (FR)
(74) Mandataire: Pontet, Bernard

(57) **Abrégé**

Un étage d'amplification filtrage et mise en forme (3) aménage les signaux de télécommande captés par un élément sensible (2), en provenance d'émetteurs de télécommande (16, 16a, 16b). Un micro-contrôleur (6) élabore des messages de commande d'après les signaux reçus.

Un intégrateur (4) est intercalé pour que le signal à l'entrée (B) du micro-contrôleur (6) ne reflète plus que les durées de sollicitation et relâchement des touches des émetteurs. Le micro-contrôleur (6) ne discrimine que deux types de séquence, par exemple appui bref et appui long. Un premier type de séquence fait défiler des propositions d'action sur l'écran d'un téléviseur (11). Le deuxième type de séquence provoque, à destination d'unités fonctionnelles (UF1, UF2, UF3), l'émission d'un message de commande correspondant à la proposition d'action en train d'être présentée.

Utilisation pour exploiter les signaux de n'importe quel émetteur de télécommande indépendamment du standard selon lequel il est codé.

## Description

La présente invention concerne un procédé pour exploiter des signaux de télécommande.

La présente invention concerne également un dispositif de télécommande pour la mise en oeuvre de ce procédé.

La présente invention concerne encore diverses unités fonctionnelles ainsi qu'une installation incluant un tel dispositif.

La commande à distance par infrarouges s'est imposée dans les domaines de l'équipement audio et audiovisuel chaque fois qu'il s'agit de provoquer des effets distants sur des équipements en vue directe à partir d'un émetteur autonome. Le succès de ce moyen de commande est tel qu'on assiste à une multiplication des boîtiers de télécommande chez l'utilisateur.

Aucune norme ou standard multiconstructeur n'existe en ce domaine, de sorte que la plupart des appareils télécommandables par infrarouges, sont incompatibles entre eux. Il y a en fait presque autant de standards que de fournisseurs sur le marché.

Pour tenter de remédier à cette multiplication des émetteurs de télécommande chez l'utilisateur, on a proposé la télécommande à apprentissage. Il s'agit d'un appareil capable dans un premier temps d'enregistrer les signaux fournis par les différents émetteurs à remplacer puis, en exploitation, de restituer ces signaux lorsque les touches ou combinaisons de touches correspondant au résultat souhaité ont été sollicitées.

Une autre approche, comme d'après le EP-A-203668, consiste à stocker dans la mémoire d'un émetteur de télécommande multistandard les principaux types de codage présents sur le marché.

L'accroissement au moins apparent de la complexité de ces télécommandes multistandard connues rend celles-ci peu satisfaisantes à l'emploi et leur fait perdre l'avantage d'ergonomie qui a fait le succès des télécommandes à infrarouges monostandard.

Les solutions de télécommandes multistandard connues ont également l'inconvénient de coûter plus cher en raison du grand nombre de touches et de moyens de stockage des différents types de codage acceptés.

Le but de la présente invention est de proposer un mode de télécommande qui soit à la fois particulièrement simple à manipuler, compatible avec un grand nombre de standards et intrinsèquement peu coûteux.

Suivant un premier aspect de l'invention, le procédé pour exploiter des signaux de télécommande, est caractérisé en ce que :
- on présente sensoriellement une proposition d'action appartenant à un cycle de propositions d'action,
- on détecte les séquences macroscopiques de présence et d'absence du signal de télécommande,
- en réponse à un premier type de séquence on commande l'exécution d'un pas de défilement dans le cycle de présentation de propositions d'action ; et
- en réponse à un deuxième type de séquence on commande une action correspondant à une proposition d'action en train d'être présentée.

Suivant un second aspect de l'invention, le dispositif de télécommande comprenant des moyens d'entrée pour recevoir et aménager des signaux de télécommande, et des moyens de traitement pour élaborer des commandes en fonction des signaux reçus, est caractérisé en ce que les moyens d'entrée sont conçus pour délivrer une indication reflétant les séquences macroscopiques de présence et d'absence du signal reçu, et en ce que les moyens de traitement comprennent des moyens pour piloter un dispositif de présentation sensorielle de propositions d'action, des moyens pour discriminer un premier et un deuxième type de séquences de présence et d'absence, des moyens pour exécuter un pas de défilement dans un cycle de présentation de propositions d'action en réponse au premier type de séquence, et des moyens pour, en réponse au deuxième type de séquence, mettre en oeuvre l'action en train d'être proposée en présentation.

Ainsi, selon l'invention, on ne cherche pas à détecter un message élaboré selon un code relativement complexe constitué d'une succession rapide de niveaux logiques "0" ou "1". On ne détecte que les présences et absences de durée macroscopique, et cela permet à l'utilisateur de composer lui-même le signal de télécommande, par exemple en appuyant et en relâchant avec le rythme voulu une touche de l'émetteur de télécommande.

Ceci est réalisable sans difficulté par l'utilisateur car le procédé selon l'invention peut ne discriminer qu'un très petit nombre de séquences typiques différentes. Pour qu'il soit malgré cela possible de réaliser de nombreuses commandes différentes, l'invention fait intervenir une présentation sensorielle des choix, avec, en réponse à un premier type de séquence, un défilement des choix présentés. Le deuxième type de séquence sert à valider le choix en cours de présentation.

L'invention est capable d'exploiter les signaux issus de pratiquement toutes les télécommandes à infrarouges du marché, car seules sont prises en compte les séquences de présence et d'absence de durée macroscopique des signaux reçus, par exemple infrarouges. Il suffit en général que la longueur d'onde de ces signaux soit compatible avec le capteur utilisé et que la modulation affectant ces signaux produise des fréquences comprises dans la bande passante du dispositif d'amplification et de filtrage que comportera en général le récepteur de télécommande selon l'invention.

La prise en compte uniquement macroscopique de la présence et de l'absence de signal signifie qu'on considère qu'il y a présence de signal même en cas de brèves absences telles que celles pouvant résulter du codage correspondant au standard de l'émetteur employé.

Le récepteur de télécommande selon l'invention comprend de préférence un dispositif d'intégration en plus des éléments traditionnellement utilisés dans les télécommandes existantes.

Le rôle du dispositif d'intégration est de masquer les disparitions de signal dont la durée est inférieure au "temps d'intégration". Par exemple 0,5 seconde.

Ainsi, seules subsistent les interruptions de durée "macroscopique", et quel que soit le type de codage utilisé par l'émetteur, le récepteur ne perçoit à la sortie du dispositif d'intégration qu'un signal qui représente, au temps d'intégration près, l'image de l'état de la touche sollicitée par l'utilisateur sur l'émetteur de télécommande.

Pour déclencher une action, l'utilisateur réitère le premier type de séquence jusqu'à ce que l'action qu'il souhaite soit présentée comme proposition d'action. Le défilement des propositions d'action peut se présenter sous la forme du défilement d'un index en regard de plusieurs propositions successives formant une liste visualisée sur un écran de télévision. Lorsque l'action désirée est désignée par l'index, l'utilisateur provoque l'émission du deuxième type de séquence pour valider le choix. Ceci déclenche par exemple l'émission d'un message de commande dans un espace de communication. Le premier type de séquence peut par exemple consister en une présence de signal pendant moins de deux secondes, et le second type de séquence peut consister en une présence de signal pendant une durée supérieure à deux secondes.

Le procédé selon l'invention n'exploite pas l'information transmise par l'émetteur qui permet au récepteur adapté au standard de l'émetteur de connaître la touche qui a été sollicitée. Cette caractéristique de l'invention permet à l'utilisateur de manipuler n'importe quelle touche de n'importe quel émetteur de télécommande adaptée, c'est à dire par exemple à infrarouges.

Si l'on utilise un émetteur de télécommande à infrarouges susceptible de commander à distance un autre appareil, il suffira de choisir une touche sans effet sur l'état de cet autre appareil au moment où l'on veut mettre en oeuvre le procédé selon l'invention.

Par exemple, si le téléviseur est en marche sur le canal n°2, toute sollicitation de la touche "2" de l'émetteur de télécommande associé à ce téléviseur n'a aucun effet sur l'état du téléviseur. Cette touche peut donc être utilisée pour mettre en oeuvre le procédé selon l'invention sans perturber l'appareil normalement associé à l'émetteur.

En dehors de la réutilisation d'émetteurs de télécommande à infrarouges existants, l'invention permet d'utiliser un émetteur dédié pouvant être aussi simple qu'un seul bouton poussoir dont l'appui provoque l'émission d'un signal infrarouge ayant une longueur d'onde compatible avec le détecteur employé dans le dispositif de réception et modulé en amplitude à une fréquence compatible avec les filtres de la partie réception et le dispositif "d'intégration", par exemple un signal infrarouge de longueur d'onde 950 nm modulé en tout ou rien à une fréquence de 10 KHz avec un rapport cyclique de 50 %. Un autre exemple d'émetteur de télécommande dédiée pourrait comporter deux boutons dont chacun émettrait l'un des types de séquence nécessaires pour la mise en oeuvre du procédé selon l'invention.

Le procédé selon l'invention peut faire l'objet d'aménagements qui dépendent du contexte dans lequel il est mis en oeuvre sans pour autant sortir du cadre de l'invention.

Lorsque le dispositf selon l'invention partage des ressources telles qu'un émetteur de télécommande à infrarouges et le moyen de présentation sensorielle, tel qu'un moyen de visualisation, il est prévu selon l'invention d'initier le procédé en sollicitant les touches de l'émetteur de télécommande d'une manière qui soit peu probable dans l'exploitation dite "normale" de l'émetteur de télécommande. A la réception de ce troisième type de séquence, les moyens de restitution visuelle sont mis à la disposition du dispositif selon l'invention.

Par exemple, un appareil mettant en oeuvre l'invention pour piloter des équipements domestiques peut être raccordé à un téléviseur par la prise SCART (dite PERITEL) et utiliser l'écran de téléviseur pour afficher des propositions d'action pouvant selon l'invention être choisies par l'utilisateur à l'aide de n'importe quel émetteur à infrarouges, en particulier celui qui est normalement associé au téléviseur. Dans ces conditions, il convient de faire en sorte qu'en dehors des cas où l'utilisateur effectue des commandes selon l'invention, l'image du téléviseur ne soit pas perturbée.

Ce problème peut être résolu au moyen par exemple d'une séquence de sollicitation des touches de l'émetteur de télécommande comme deux appuis de courte durée et un appui de longue durée qui se succèdent avec un temps limité entre chaque appui ou bien toute autre séquence faisant intervenir les paramètres nombre d'appuis et temps. Lorsque la séquence prévue a été exécutée, le dispositif de télécommande selon l'invention utilise l'écran du téléviseur pour présenter des propositions d'action à l'utilisateur. Le retour au mode de fonctionnement "téléviseur" s'effectue au bout d'un temps d'inactivité déterminé ou si l'utilisateur émet le deuxième type de séquence alors que l'action "FIN" lui est proposée par présentation.

De nombreux modes de mise en oeuvre de l'invention sont possibles dans des appareils où les moyens de présentation sensorielle sont en permanence au service du procédé selon l'invention. Le dispositif selon l'invention peut lui-même être intégré dans l'appareil. Il peut par exemple s'agir d'un ensemble audio portant en façade des pictogrammes ou de simples voyants lumineux identifiables à une distance de quelques mètres, utilisables pour présenter séquentiellement des propositions d'action à chaque sollicitation de courte durée d'une touche de l'émetteur, la commande ne devenant effective qu'après un appui de longue durée sur la touche. Le procédé selon l'invention permet de sélectionner non seulement des commandes à effet simple comme une mise en marche ou une mise à l'arrêt, mais aussi des commandes faisant varier un paramètre de manière interactive comme la diminution ou l'augmentation d'un volume sonore ou de tout autre paramètre.

Dans ce dernier cas il suffit de maintenir la touche appuyée au-delà du temps prévu pour valider le choix de la commande et ceci jusqu'à obtention de l'effet désiré. L'ergonomie du procédé peut encore être améliorée en gérant de manière dynamique l'ordre de présentation des propositions d'action dans l'ensemble de celles qui sont possibles à un instant donné. Par exemple, si en l'absence de validation, des propositions se succèdent dans un ordre déterminé: fonction 1, diminution paramètre 1, augmentation paramètre 1, diminution paramètre 2, augmentation paramètre 2, fonction 2 ..., et si l'utilisateur a validé le choix "augmentation du paramètre 1", il est avantageux de lui reproposer lors du prochain appui le réglage du même paramètre en sens inverse, c'est à dire "diminution du paramètre 1" et non pas "diminution du paramètre 2", de manière à rester sur le réglage du même paramètre en passant alternativement d'un sens de réglage à l'autre tant que l'utilisateur n'est pas satisfait du résultat. L'ordre normal dans la présentation des propositions d'action est de nouveau respecté lorsqu'est reçue une séquence du premier type.

Selon un troisième aspect de l'invention, l'unité fonctionnelle est caractérisée en ce qu'elle intègre un dispositif de télécommande selon le deuxième aspect, et en ce que le dispositif de présentation sensorielle, tel qu'écran d'affichage, pictogrammes et analogues sur une façade de l'unité fonctionnelle, appartient à des moyens d'entrée/sortie reliés pour être commandés par le dispositif de télécommande en fonction de signaux reçus par le dispositif de télécommande.

Selon un quatrième aspect de l'invention, l'unité fonctionnelle ayant une ressource locale est caractérisée en ce qu'elle incorpore un dispositif de télécommande selon le second aspect, et en ce que les moyens pour mettre en oeuvre l'action en train d'être proposée en présentation comprennent des moyens pour émettre des messages de commande à travers un espace de communication par lequel le dispositif est reliable avec des unités fonctionnelles d'action.

Selon un cinquième aspect de l'invention, une unité fonctionnelle telle que magnétoscope, lecteur de vidéodisques etc ... est caractérisée en ce qu'elle incorpore un dispositif de télécommande selon le deuxième aspect.

Selon un sixième aspect de l'invention, l'installation comprend des unités fonctionnelles reliables à un espace de communication pour recevoir des messages de commande à travers l'espace de communication, et un dispositif de commande selon le deuxième aspect, reliable audit espace de communication pour transmettre à travers cet espace de communication des messages de commande élaborés sur la base des séquences macroscopiques reçues et destinés aux unités fonctionnelles de l'installation.

D'autres particularités et avantages de l'invention ressortiront encore de la description ci-après, relative à des exemples non limitatifs.

Aux dessins annexés
- La figure 1 est un schéma-bloc d'une installation selon l'invention ;
- La figure 2 est un chronogramme de différents états et signaux dans l'installation de la figure 1 ;
- La figure 3 est un organigramme de fonctionnement du micro-contrôleur de la figure 1 ;
- La figure 4 est un autre exemple d'organigramme de fonctionnement du micro-contrôleur de la figure 1 ;
- La figure 5 est un schéma-bloc de l'application de l'invention à la commande d'un magnétoscope ; et
- La figure 6 est un schéma-bloc de l'application de l'invention à une unité fonctionnelle incorporant des moyens de visualisation.

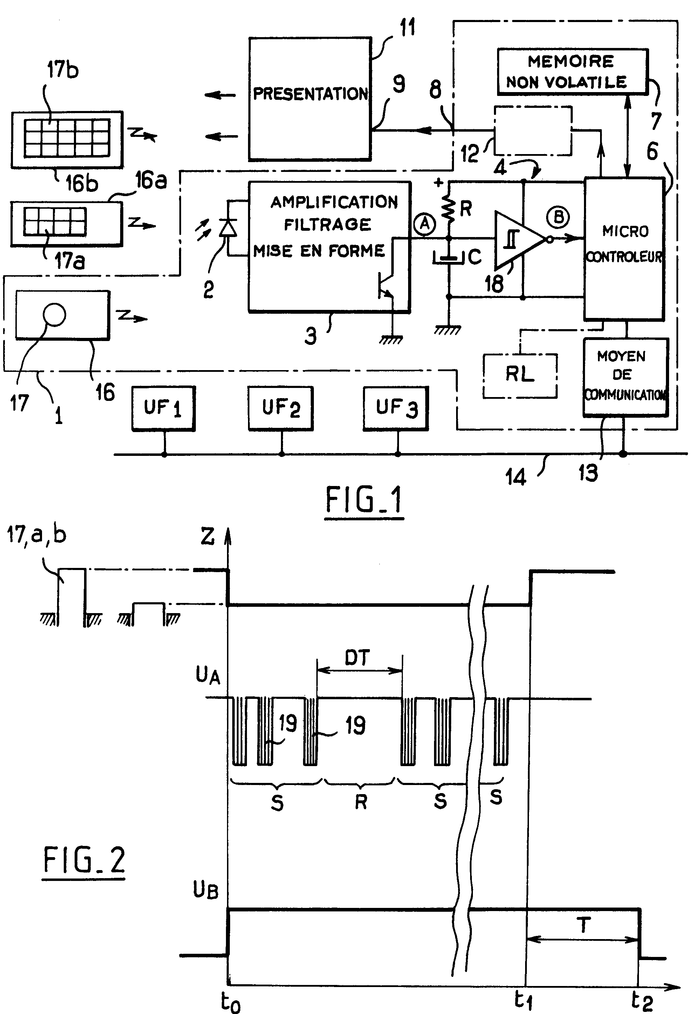

Dans l'exemple représenté à la figure 1, le dispositif de télécommande 1 selon l'invention comprend un capteur 2 sensible au rayonnement infrarouge, monté aux bornes d'entrée d'un étage d'amplification, filtrage et mise en forme de signal 3 dont la sortie A constitue l'entrée d'un étage intégrateur 4. La sortie de signal B de l'étage intégrateur 4 est reliée à une entrée d'un micro-contrôleur 6 qui est relié à une mémoire non-volatile 7 ainsi qu'à une sortie 8 du dispositif de télécommande qui délivre un signal de pilotage de la présentation. La sortie 8 est raccordée à une entrée 9 d'un appareil de présentation 11 tel qu'un téléviseur. L'entrée 9 peut être constituée par la prise dite "de péritélévision" ou "PERITEL" du téléviseur, c'est à dire la prise normalisée comprenant autant de broches qu'il y a de types de signal audio-vidéo possibles. L'entrée 9 du téléviseur peut en variante être constituée par la prise d'antenne, auquel cas le micro-contrôleur 6 est relié à la sortie 8 par l'intermédiaire d'un modulateur haute fréquence 12.

Le micro-contrôleur 6 est encore relié à un espace de communication bidirectionnel 14 par l'intermédiaire d'un moyen de communication 13. L'espace de communication bidirectionnel 14 peut être constitué par le réseau d'alimentation électrique d'un local, auquel cas le moyen de communication 13 consiste en un modem capable d'élaborer et de décripter des messages transmissibles par le procédé des "courants porteurs". Mais l'espace de communication bidirectionnel peut également consister en un moyen filaire dédié ou en un espace perméable aux rayonnements infrarouges, aux ondes radio, etc ... Des unités fonctionnelles UF1, UF2 et UF3 sont également reliées à l'espace de commuication 14. Ces unités fonctionnelles sont des appareils que l'on souhaite pouvoir commander à l'aide du dispositif de télécommande 1, par exemple des équipements électroménagers domestiques. La mémoire non-volatile 7 contient d'une part plusieurs tableaux ou listes de propositions d'action que le micro-contrôleur 6 peut faire visualiser par le téléviseur 11, et d'autre part des messages de commande préétablis que le micro-contrôleur 6 peut transmettre à l'espace 14 via le moyen de communication 13.

Le dispositif de télécommande 1 comprend en outre un émetteur de télécommande dédié 16 muni d'une touche unique 17 qui commande une émission continue de rayonnement infrarouge lorsqu'elle est enfoncée et l'interruption de ce rayonnement lorsqu'elle est relâchée.

Mais le dispositif de télécommande 1 est également utilisable avec des émetteurs de télécommande 16a et 16b comportant de multiples touches 17a et respectivement 17b dont chacune commande l'émission d'un signal correspondant à une commande déterminée d'un appareil récepteur déterminé, ce signal étant caractérisé par une succession rapide, selon un rythme déterminé, de coupures et de rétablissements du rayonnement infrarouge. Ce rythme est en général très rapide, et en particulier trop rapide pour pouvoir être imité par une succession d'appuis et de relâchements de la touche 17 de l'émetteur de télécommande 16.

On va maintenant exposer le fonctionnement de l'installation représentée à la figure 1, en s'aidant des chronogrammes de la figure 2.

Le chronogramme Z montre un exemple d'actionnement et de relâchement de la touche 17 de l'émetteur 16 ou de l'une des touches 17a ou 17b de l'émetteur 16a ou 16b. La touche est relâchée jusqu'à l'instant t₀, enfoncée à l'instant t₀, maintenue enfoncée jusqu'à l'instant t₁ où elle est de nouveau relâchée. Dans le cas de l'émetteur 16, le signal reçu par le capteur 2 ressemble au chronogramme Z, de même que le signal au point A de sortie de l'étage 3 d'amplification filtrage et mise en forme. A la sortie B de l'étage d'intégration 4 qui comprend un circuit RC à l'entrée d'un amplificateur 18 à seuil de montée et de descente différents, le signal correspond au chronogramme U_{B}, avec une montée au niveau logique 1 à l'instant t₀ où l'on enfonce la touche 17, et une redescente au niveau logique 0 à l'instant t₂ = t₁ + T avec T correspondant au délai de coupure introduit par le condensateur C se chargeant à travers la résistance R jusqu'à ce que le seuil de montée de l'amplificateur 18 soit atteint.

Ainsi, le signal à l'entrée B du micro-contrôleur 6 est une image de la sollicitation de la touche 17 de l'émetteur 16 exception faite du retard T avec lequel le niveau logique 0 est rétabli.

Si au lieu de l'émetteur 16 on a utilisé l'émetteur 16a ou 16b, et qu'on a appuyé sur une touche quelconque 17a ou 17b de cet émetteur, on a produit automatiquement une succession rapide de coupures et rétablissements du rayonnement, et il en a résulté à la sortie A de l'étage d'amplification filtrage et mise en forme la fonction en créneau irrégulier correspondant par exemple au chronogramme UA. Cette fonction correspond à des successions identiques S de signaux codés, séparés par des repos R. La durée T est choisie suffisamment grande pour être supérieure au plus grand intervalle de temps DT que l'on est susceptible de rencontrer en pratique à l'entrée A de l'étage d'intégration 4 entre deux présences de signal. Ainsi, chaque présence de signal telle que 19 réinitialise la durée T et par conséquent le signal U_{B} ne retombe au niveau logique 0 qu'après écoulement de la durée T après que la touche 17a ou 17b a été relâchée.

En d'autres termes, le signal présent au point B est le même quel que soit l'émetteur de télécommande 16, 16a ou 16b utilisé pour autant qu'il y ait compatibilité physique entre les signaux émis par l'émetteur utilisé et l'étage d'amplification filtrage et mise en forme 3.

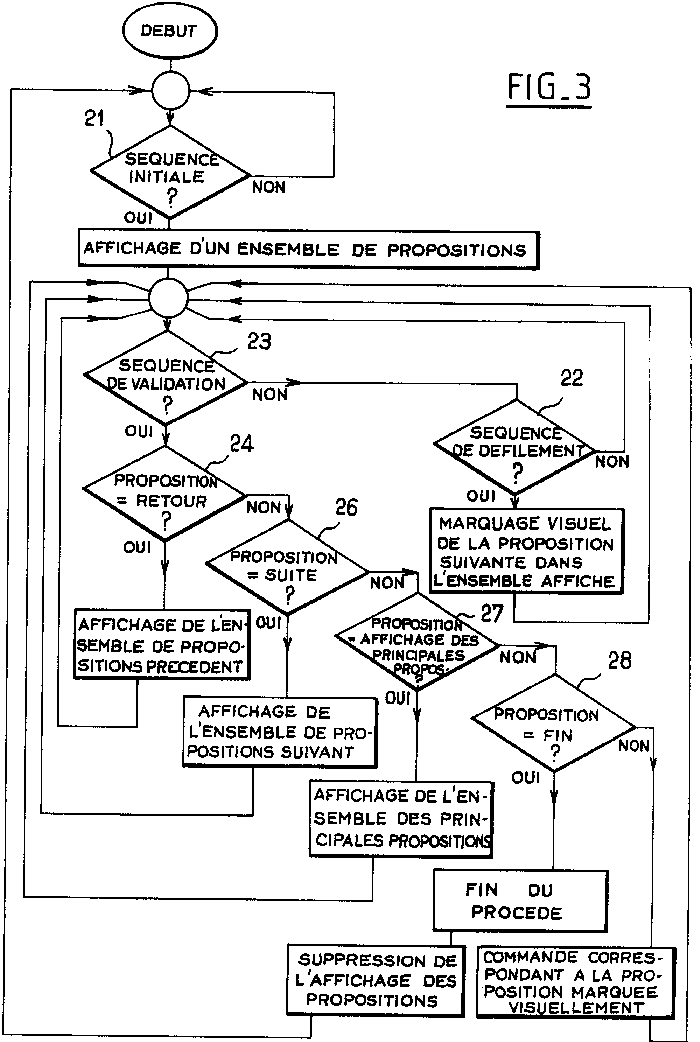

On va maintenant décrire le traitement du signal UB par le micro-contrôleur 6 en référence à la figure 3.

Pour commencer une session, l'utilisateur doit provoquer manuellement à l'aide de la touche 17, 17a ou 17b une succession caractéristique de présences et d'absences de signal U_{B}, par exemple deux présences brèves suivies d'une présence longue. Cela est détecté par le micro-contrôleur 6 au moyen d'un test 21 et le micro-contrôleur prend la commande du téléviseur 11 et provoque à travers la sortie 8 l'affichage par le téléviseur 11 d'un ensemble d'actions possibles avec par exemple désignation de la première action proposée au moyen d'un index vidéo. La prise de commande du téléviseur 11 s'opère de manière connue en soi par un signal de préemption approprié appliqué à une broche prévue à cet effet dans la prise PERITEL 9. Il peut s'agir du mode de préemption dit "en commutation lente", par lequel le dispositif selon l'invention commande entièrement l'image restituée par le téléviseur ; il peut aussi s'agir du mode de préemption dit "en commutation rapide" consistant à incruster une image vidéo dans l'image normalement restituée par le téléviseur.

Au contraire, si l'utilisateur ne provoque pas l'émission de la séquence de début de session, le micro-contrôleur 6 reste insensible aux signaux se présentant à la sortie B de l'intégrateur 4, ce qui permet par exemple d'utiliser les émetteurs de télécommande 16a ou 16b pour commander normalement le téléviseur 11.

Si l'entrée 9 du téléviseur 11 est constituée non pas par la prise PERITEL mais par la prise d'antenne, l'utilisateur ouvre la session non pas par une séquence typique, mais en mettant le téléviseur en service sur le canal correspondant au modulateur 12. Pour cela, il peut utiliser l'émetteur de télécommande 16b associé au téléviseur, et il pourra ensuite avantageusement effectuer l'ensemble de la session avec cet émetteur de télécommande.

La session étant initiée, le micro-contrôleur 6 discrimine ensuite entre un premier et un deuxième types de séquences. Le premier type de séquence est par exemple du type représenté pour U_{B} à la figure 2, avec t₂ - t₀ < 2s. Chaque fois que le micro-contrôleur 6 détecte ce premier type de séquence, il provoque sur l'écran du téléviseur 11 un déplacement de l'index vidéo d'un pas de défilement pour proposer à l'utilisateur l'action suivante parmi celles dont la liste est présentée sur le téléviseur 11. Ceci est réalisé par le test 22. Quand l'index arrive en bas du tableau des actions proposables, il revient au sommet du tableau si une séquence du premier type est de nouveau détectée.

Si au contraire le micro-contrôleur 6 détecte par un test 23 une séquence U_{B} du deuxième type, caractérisée par exemple par t₂ - t₀ > 2s, il valide l'action désignée par l'index au moment où cette séquence est reçue.

Les actions proposées peuvent être internes ou distantes. Les actions internes au dispositif de télécommande peuvent en particulier viser à remplacer le tableau des actions proposables par le tableau qui avait été présenté précédemment (test 24) ou par le tableau suivant (test 26), ou par un tableau présentant l'ensemble des principales branches d'action proposées (test 27). Il peut encore s'agir d'une action interne consistant à mettre fin à la session de télécommande (test 28). Une réponse négative aux quatre tests 24, 26, 27, 28 signifie que l'action validée par l'utilisateur est une action distante, c'est à dire concernant une unité fonctionnelle UF1, UF2 ou UF3 extérieure au dispositif de télécommande, et dans ce cas le micro-contrôleur 6 diffuse à travers le moyen de communication 13 un message de commande convenablement adressé dans l'espace de communication 14.

De manière non représentée, si l'utilisateur reste inactif pendant un temps prédéterminé à un stade quelconque postérieur à l'ouverture de session, la session se termine automatiquement comme si la réponse au test 28 avait été positive.

Dans l'exemple de la figure 1, le dispositif 1, à l'exception de l'émetteur 16, peut se présenter sous la forme d'un boîtier de commande, ou sous la forme d'une unité ayant une ressource locale RL (en traits mixtes à la figure 1) par exemple une fonction d'éclairage. Dans ce cas les propositions d'action présentées peuvent concerner aussi la ressource locale RL.

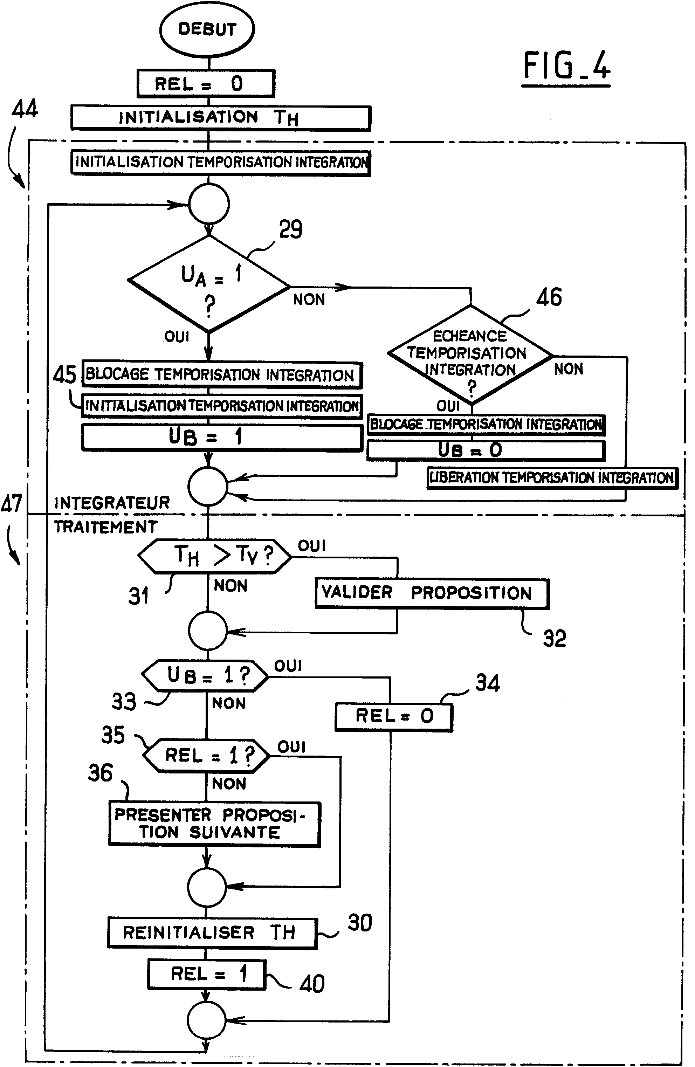

L'exemple de la figure 4 ne sera décrit qu'en ce qui concerne ses différences par rapport à celui des figures 1 à 3.

De manière non représentée, l'organigramme de la figure 4 permet de supprimer l'intégrateur 4 de la figure 1. Il est remplacé par un "intégrateur" 44 sous forme de logiciel. Cet intégrateur comprend un test 29 pour détecter si il y a ou non présence de signal au point A. En cas de présence (U_{A} = 1), le signal. U_{B} est dit "présent" (U_{B} = 1) et une temporisation d'intégration est constamment réinitialisée (étape 45).

En cas d'absence de signal à l'entrée A, une sortie U_{B} = 1 est quand même fournie tant que la temporisation n'est pas écoulée. La durée de la temporisation correspond par exemple à la durée T de la figure 2. Lorsqu'un test 46 détecte que cette temporisation est écoulée sans que le signal ait reparu, le signal se sortie de l'intégrateur est dit "absent" (U_{B} = 0) . Ainsi le niveau logique pris en compte à la sortie de l'intégrateur logiciel 44 correspond au niveau de tension U_{B} représenté à la figure 2 pour une même action sur une touche 17, 17a ou 17b. Lorsque U_{B} = 1, on dit que la touche 17, 17a ou 17b est "considérée comme sollicitée".

Le logiciel de la figure 4 comprend en outre une partie "traitement" 47 dont l'entrée correspond à la sortie de la partie "intégrateur".

Un test 31 détermine si l'état T_{H} d'un compteur de temps dépasse un seuil T_{V} correspondant à la durée au-delà de laquelle l'appui sur la touche 17, 17a ou 17b correspond à une validation de proposition. Pour des raisons qui apparaîtront plus loin, l'état de comptage du temps T_{H} est constamment réinitialisé si le signal U_{B} est égal à zéro. Par conséquent, T_{H} > T_{V} signifie que U_{B} = 1 depuis un temps supérieur à T_{V} et par conséquent on valide la proposition en cours de présentation (commande 32). Au contraire, si T_{H} < T_{V}, la commande 32 est court-circuitée. Quel que soit le résultat du test 31, on teste ensuite la valeur de U_{B} (test 33). Si U_{B} = 1, c'est que la touche 17, 17a, 17b est toujours considérée comme sollicitée et on est renvoyé au début de l'intégrateur 44 en mettant simplement à la valeur "0" un indicateur binaire de relâchement préexistant REL (commande 34). Autrement dit, tant que la touche est considérée comme sollicitée la présentation n'est pas modifiée. On obtient ainsi deux résultats. D'une part, tant que la touche est considérée comme sollicitée et que TH < T_{V}, on ne peut pas savoir si l'utilisateur veut simplement passer au choix suivant ou valider la proposition actuellement présentée. D'autre part, aussi longtemps que T_{H} > T_{V}, la proposition est validée répétitivement, ce qui permet de réaliser une fonction "réglage dans un sens" tant que la touche est considérée comme sollicitée (U_{B} = 1).

Si on détecte U_{B} = 0, on teste la valeur de l'indicateur binaire de relâchement préexistant REL (test 35). Si REL = 0, c'est que le relâchement de la touche 17, 17a , 17b (la valeur U_{B} = 0) est détecté pour la première fois depuis la plus récente sollicitation de la touche 17, 17a, 17b.

Dans ce cas on présente la proposition suivante (commande 36), puis on réinitialise T_{H} (commande 30) et on pose REL = 1 (commande 40) de façon à indiquer que le relâchement de la touche a maintenant été détecté et pris en compte en ce qui concerne la présentation des propositions. Ensuite, on revient au début du logiciel d'intégration. Au cycle suivant, si U_{B} est toujours égal à 0, le test 35 relèvera que REL = 1 et la commande 36 "PRESENTATION PROPOSITION SUIVANTE" sera sautée, on passera directement du test 35 sur REL à la commande 30 de réinitialisation de T_{H}.

Avec ce logiciel de traitement, même si l'utilisateur a sollicité la touche suffisamment longuement pour valider une proposition, il y a ensuite, lors du relâchement de la touche, présentation de la proposition suivante.

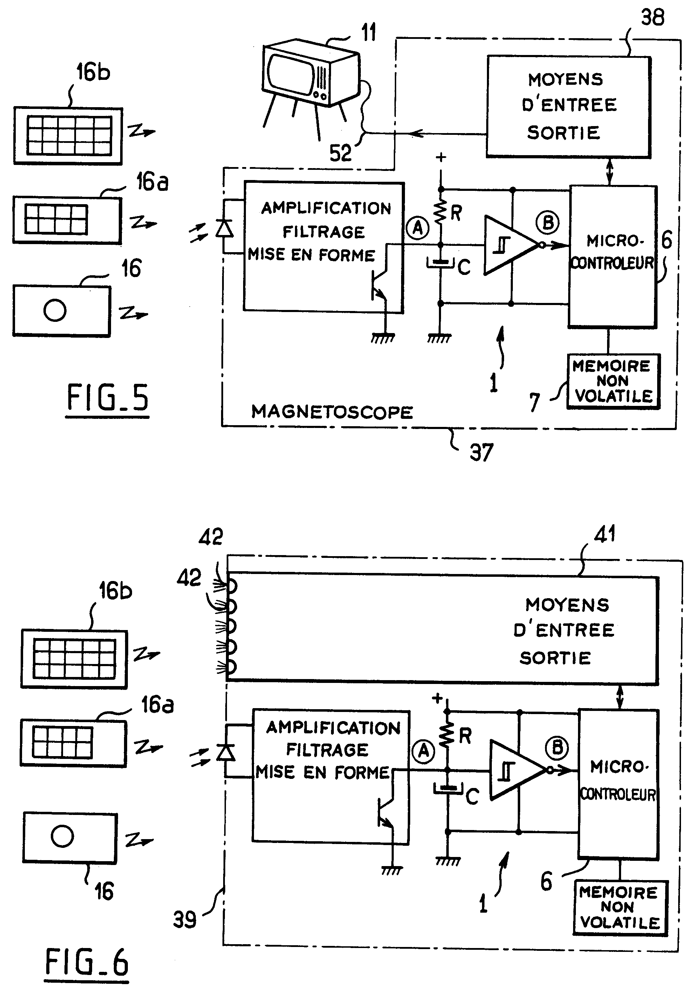

Dans l'exemple représenté à la figure 5, le dispositif de télécommande 1 ne communique pas avec un espace de communication. Il est au contraire intégré dans un magnétoscope 37 et le micro-contrôleur 6 pilote les moyens d'entrée/sortie 38 du magnétoscope, c'est à dire tout l'appareillage d'enregistrement et de restitution de signaux permettant au magnétoscope d'enregistrer des émissions télévisées ou de restituer sur le téléviseur 11 des séquences vidéo enregistrées sur bande. Dans le cadre de l'invention, le micro-contrôleur 6, lorsqu'il a reçu la séquence d'ouverture de session de télécommande, prend la commande des moyens d'entrée/sortie 38 et indirectement du téléviseur 11 pour faire visualiser par le téléviseur 11 les tableaux de propositions d'action contenus dans la mémoire non-volatile 7.

Ce mode de réalisation de l'invention a l'avantage que l'émetteur de télécommande tel que 16b associé au téléviseur 11 peut également, quel que soit son standard, être utilisé pour commander le magnétoscope 37 sans que le fabricant du magnétoscope ait besoin de fournir un boîtier de télécommande spécifique. De plus, la télécommande agit sur le téléviseur via la liaison 52 normalement prévue entre téléviseur et magnétoscope, sans qu'un fil supplémentaire soit nécessaire.

Dans l'exemple représenté à la figure 6, le dispositif de télécommande 1 est intégré à une unité fonctionnelle 39, par exemple un appareil audio dont les moyens d'entrée/sortie 41 comprennent notamment des voyants lumineux ou pictogrammes 42 sur la façade de l'unité fonctionnelle. Par exemple, un pictogramme 42 signifie "marche-arrêt", un autre signifie "augmentation du volume sonore", un troisième "baisse du volume sonore" etc... Le micro-contrôleur 6 est relié aux moyens d'entrée/sortie 41 et les voyants ou pictogrammes 42 constituent les moyens de présentation permettant selon l'invention de présenter des propositions d'action. Chaque fois que l'utilisateur appuie relativement brièvement sur une touche d'un émetteur de télécommande 16, 16a ou 16b, un pictogramme 42 s'illumine et le précédent s'éteint. Si l'utilisateur presse plus longuement la touche, le micro-contrôleur effectue la commande correspondant au pictogramme qui est illuminé. Si cette commande correspond à un réglage, par exemple l'augmentation du volume sonore, le micro-contrôleur fait varier progressivement le volume sonore jusqu'à ce que le volume sonore désiré soit atteint. Une nouvelle pression brève sur une touche d'émetteur 16, 16a ou 16b, provoque, de la part du micro-contrôleur 6, la désignation du pictogramme correspondant au même réglage dans l'autre sens, c'est à dire à la baisse du volume sonore pour permettre à l'utilisateur d'affiner le réglage.

Bien entendu, l'invention n'est pas limitée aux exemples décrits et représentés.

La discrimination entre les deux types de séquences du signal et l'élaboration des commandes correspondantes peuvent être réalisées par voies électroniques. Les signaux de télécommande peuvent employer un autre support de transmission que les rayonnements infrarouges.

De plus la présentation des propositions d'action peut faire appel à d'autres ressources sensorielles que la vision, par exemple la synthèse vocale ou encore un codeur Braille exploitant le sens du toucher.

Une "présence" de signal correspond, au sens de la présente invention, non pas nécessairement à une augmentation d'une grandeur physique, mais plus généralement à la variation d'une grandeur physique ou logique dans un sens qui est caractéristique du fait qu'une touche telle que 17, 17a ou 17b a été sollicitée. Le diagramme U_{A} de la figure 2 donne d'ailleurs un exemple où la "présence" du signal produit une baisse de potentiel.

L'organigramme de traitement 47 de la figure 4 est applicable avec l'intégrateur électronique 4 de la figure 1. L'organigramme 47 peut encore être remplacé par un organigramme selon lequel le pas de défilement de la présentation a lieu dès le début de la sollicitation d'une touche 17, 17a, 17b, l'utilisateur ne validant l'action nouvellement proposée que s'il maintient suffisamment longtemps sa sollicitation sur la touche. On peut encore concevoir qu'en cas de sollicitation longue, la validation de l'action ne s'accompagne pas de l'exécution d'un pas de défilement.

## Revendications

1. Procédé pour exploiter des signaux de télécommande, caractérisé en ce que :
- on présente sensoriellement une proposition d'action appartenant à un cycle de propositions d'action,
- on détecte les séquences macroscopiques de présence et d'absence du signal de télécommande,
- en réponse à un premier type de séquence on commande l'exécution d'un pas de défilement dans le cycle de présentation de propositions d'action ; et
- en réponse à un deuxième type de séquence on commande une action correspondant à une proposition d'action en train d'être présentée.

2. Procédé selon la revendication 1, caractérisé en ce que pour détecter les séquences, on traite les signaux pour supprimer les brèves interruptions de signal et laisser subsister les interruptions macroscopiques.

3. Procédé selon la revendication 1 ou 2, caractérisé en ce que pour commander une action correspondant à une proposition d'action en cours de présentation, on envoie un message de commande dans un espace de communication (14).

4. Procédé selon l'une des revendications 1 à 3, caractérisé en ce que pour présenter sensoriellement les propositions d'action et commander l'exécution des pas de présentation, on pilote une unité de présentation vidéo et/ou audio telle qu'un téléviseur (11).

5. Procédé selon la revendication 4, caractérisé en ce qu'on pilote l'unité de présentation vidéo et/ou audio à travers une prise de péritélévision (9) du moyen de présentation vidéo et/ou audio (11).

6. Procédé selon l'une des revendications 4 ou 5, caractérisé en ce qu'au début d'une session de traitement, on envoie à l'unité de présentation (11) un ordre de préemption en faveur de la session de télécommande.

7. Procédé selon l'une des revendications 1 à 6, caractérisé en ce qu'on démarre une session de télécommande lorsqu'on détecte un troisième type de séquence.

8. Procédé selon l'une des revendications 1 à 7, caractérisé en ce qu'on termine une session de télécommande lorsqu'on reçoit le deuxième type de séquence alors que la fin de session est proposée par présentation (test 28).

9. Procédé selon l'une des revendications 1 à 8, caractérisé en ce qu'on termine une session de traitement lorsqu'arrive à terme une temporisation réinitialisée chaque fois qu'une séquence est reçue.

10. Procédé selon l'une des revendications 4 ou 5, caractérisé en ce que pour présenter sensoriellement les propositions d'action et commander l'exécution des pas de présentation, on module un signal que l'on envoie dans une prise d'antenne de l'unité de présentation vidéo et/ou audio (11).

11. Procédé selon l'une des revendications 1 à 10, caractérisé en ce que sur réception d'une séquence du deuxième type alors qu'un sens de réglage d'un paramètre est proposé par présentation, on commande une variation du réglage dans le sens proposé tant qu'on reçoit une séquence prolongeant la séquence du deuxième type.

12. Procédé selon l'une des revendications 1 à 11, caractérisé en ce qu'après avoir émis une commande de réglage dans un premier sens, on propose par présentation l'autre sens de réglage du même paramètre.

13. Procédé selon l'une des revendications 1 à 12, caractérisé en ce qu'on présente comme proposition d'action au moins une proposition de remplacement du cycle de présentation par un autre cycle de présentation portant sur d'autres propositions d'action.

14. Procédé selon la revendication 13, caractérisé en ce qu'en réponse au deuxième type de séquence on commande une action interne de remplacement du cycle de présentation en cas de réception du deuxième type de séquence pendant la présentation de la proposition de changement de cycle, et en ce qu'on émet un message de commande à travers un espace de communication (14) en cas de réception du deuxième type de séquence pendant la présentation d'une proposition d'action distante.

15. Procédé selon l'une des revendications 1 à 14, caractérisé en ce qu'en réponse au deuxième type de séquence, en plus de commander l'action, on commande aussi l'exécution d'un pas de défilement dans le cycle de présentation.

16. Dispositif de télécommande comprenant des moyens d'entrée (3, 4, 44) pour recevoir et aménager des signaux de télécommande, et des moyens de traitement (6, 7, 12, 13, 47) pour élaborer des commandes en fonction des signaux reçus, caractérisé en ce que les moyens d'entrée (3, 4, 44) sont conçus pour délivrer une indication (U_{B}) reflétant les séquences macroscopiques de présence et d'absence du signal reçu, et en ce que les moyens de traitement comprennent des moyens pour piloter un dispositif de présentation sensorielle de propositions d'action (11, 42), des moyens pour discriminer un premier et un deuxième type de séquences de présence et d'absence, des moyens pour exécuter un pas de défilement dans un cycle de présentation de propositions d'action en réponse au premier type de séquence, et des moyens pour, en réponse au deuxième type de séquence, mettre en oeuvre l'action en train d'être proposée en présentation.

17. Dispositif selon la revendication 16, caractérisé en ce que les moyens pour piloter le dispositif de présentation sensorielle (11, 42) sont capables de commander la présentation sélective d'au moins deux cycles de propositions d'action différents comportant chacun au moins une proposition d'action consistant à changer le cycle de proposition d'actions en train d'être présenté.

18. Dispositif selon l'une des revendications 16 ou 17, caractérisé en ce que les moyens d'entrée (4, 44) comprennent des moyens (45) pour supprimer les brèves absences de signal.

19. Dispositif selon la revendication 18, caractérisé en ce que les moyens pour supprimer les brèves absences de signal comprennent un montage intégrateur (4).

20. Dispositif selon la revendication 19, caractérisé en ce que les moyens pour supprimer les brèves absences de signal comprennent une temporisation (45) maintenant un certain temps (T) après chaque fin de présence du signal incident, une sortie correspondant à une présence de signal.

21. Dispositif selon l'une des revendications 16 à 20, caractérisé en ce qu'il comprend un émetteur de télécommande (16) comprenant une unique commande d'émission de signaux (17).

22. Dispositif selon l'une des revendications 16 à 21, caractérisé en ce qu'il comprend un émetteur de télécommande comprenant une commande de défilement, commandant l'envoi du premier type de séquence, et une commande de validation, commandant l'envoi du deuxième type de séquence.

23. Dispositif selon l'une des revendications 16 à 22, caractérisé en ce que les moyens pour piloter le dispositif de présentation sensorielle ont une sortie (8) reliable à une prise de péritélévision (9) d'un appareil audio et/ou vidéo tel qu'un téléviseur (11).

24. Dispositif selon l'une des revendications 16 à 22, caractérisé en ce que les moyens pour piloter le dispositif de présentation sensorielle comprennent un modulateur (12) et sont reliables à la prise d'antenne (9) d'un appareil audio et/ou vidéo tel qu'un téléviseur (11).

25. Dispositif selon l'une des revendications 16 à 24, caractérisé en ce qu'il est intégré à une unité fonctionnelle (37), telle que magnétoscope, lecteur de vidéo-disques, ou analogues pour permettre la télécommande de l'unité fonctionnelle à partir de l'émetteur de télécommande (16) initialement prévu pour la télécommande du téléviseur (11) avec lequel l'unité fonctionnelle est couplée.

26. Dispositif selon l'une des revendications 16 à 25, caractérisé en ce qu'il incorpore le dispositif de présentation sensorielle.

27. Dispositif selon la revendication 25, caractérisé en ce que les moyens pour piloter le dispositif de présentation sont reliés au téléviseur via la liaison (52) normalement prévue entre l'unité fonctionnelle (37) et le téléviseur (11), pour commander l'exécution de la présentation sensorielle par le téléviseur.

28. Dispositif selon l'une des revendications 16 à 27, caractérisé en ce que les moyens pour mettre en oeuvre l'action en train d'être proposée en présentation comprennent des moyens (13) pour émettre des messages de commande à travers un espace de communication (14) par lequel le dispositif est reliable avec des unités fonctionnelles d'action (UF1, UF2, UF3).

29. Unité fonctionnelle, caractérisée en ce qu'elle incorpore un dispositif de télécommande selon l'une des revendications 16 à 23, et en ce que le dispositif de présentation sensorielle, tel qu'écran d'affichage, pictogrammes et analogues (42) sur une façade de l'unité fonctionnelle, appartient à des moyens d'entrée/sortie (41) reliés pour être commandés par le dispositif de télécommande (1) en fonction des signaux reçus par le dispositif de télécommande.

30. Unité fonctionnelle ayant une ressource locale (RL), caractérisée en ce qu'elle incorpore un dispositif de télécommande selon l'une des revendications 16 à 23, et en ce que les moyens pour mettre en oeuvre l'action en train d'être proposée en présentation comprennent des moyens (13) pour émettre des messages de commande à travers un espace de communication (14) par lequel le dispositif est reliable avec des unités fonctionnelles d'action (UF1, UF2, UF3).

31. Unité fonctionnelle, telle que magnétoscope, lecteur de vidéodisques etc ..., caractérisée en ce qu'elle incorpore un dispositif de télécommande selon l'une des revendications 16 à 28.

32. Installation comprenant des unités fonctionnelles (UF1, UF2, UF3) reliables à un espace de communication (14) pour recevoir des messages de commande à travers l'espace de communication, et un dispositif de télécommande (1) selon la revendication 24 reliable audit espace de communication (14) pour transmettre à travers cet espace de communication des messages de commande élaborés sur la base des séquences macroscopiques reçues, ces messages étant destinés aux unités fonctionnelles de l'installation.
